Europäisches Patentamt

European Patent Office

Office européen des brevets

(19)

(11) Publication number : **0 501 906 A1**

(12) # EUROPEAN PATENT APPLICATION

(21) Application number : **92610012.4**

(22) Date of filing : **21.02.92**

(51) Int. Cl.⁵ : **G06K 11/18,** G06K 11/20

(30) Priority : **01.03.91 DK 377/91**

(43) Date of publication of application :
**02.09.92 Bulletin 92/36**

(84) Designated Contracting States :
**AT BE CH DE DK ES FR GB GR IT LI LU MC NL
PT SE**

(71) Applicant : **HARDI INTERNATIONAL A/S
38, Helgeshoj Alle
DK-2630 Taastrup (DK)**

(72) Inventor : **Soelberg, Peter
57, Sct. Annagade
DK-3000 Helsingor (DK)**

(74) Representative : **Siiger, Joergen et al
c/o Chas. Hude H.C. Andersens Boulevard 33
DK-1553 Copenhagen V (DK)**

(54) **Contactless joystick.**

(57)   Contactless joystick comprising a stick swingable about a ball-and-socket joint, said stick comprising an upper portion and a lower portion displacable relative to the upper portion. An elastic spring connected to the upper portion and the lower portion biases the lower portion in a downwards direction. Magnetizing means are mounted at the end of the lower portion and a number of hall effect switches are mounted on a subjacent plate. According to the invention, the lower biased portion of the stick is adapted to engage indentations in positions corresponding to the positions of the hall effect switches. It is thereby possible to distinguish between a large number of positions while, at the same time, the associated electronics are made simpler.

Fig.1

EP 0 501 906 A1

Jouve, 18, rue Saint-Denis, 75001 PARIS

Fig.8

The invention relates to a contactless joystick comprising a stick swingable about a ball-and-socket joint, said stick comprising an upper portion and a lower portion displacable relative to the upper portion, an elastic spring connected to the upper portion and the lower portion and biasing the lower portion, magnetizing means mounted at the end of the lower portion and a number of hall effect switches mounted on a subjacent plate, the lower biased portion of the stick being adapted to engage indentations in positions corresponding to the positions of the transducers.

US patent No. 4,459,578 discloses a joystick where two movable arms are provided with magnets. The joystick may be moved in such a manner that the magnets are guided to the proximity of one of a number of firmly mounted hall elements. By means of analog signals from the hall elements, the system is able to provide information on the position of the joystick in a XY plane. If it is required to distinguish between a large number of positions of the joystick, the associated electronic circuits become rather comprehensive and complicated.

US patent No. 4,825,157 discloses a contactless joystick, where an electromagnet has been mounted on a movable stick, said electromagnet magnetizing the stick. Four hall elements are placed perpendicularly to the stick, said hall elements providing information on the position of the stick. The associated electronic circuits will, however, become relatively complicated if a larger number of hall elements is to be used.

joystick with a magnet capable of influencing one out of several subjacent hall elements placed in a matrix-like pattern. The position of the joystick is determined by means of a parallel reading of the signals from the hall elements. If a large number of hall elements is to be used, the corresponding electronic circuits become rather complicated.

The object of the invention is to demonstrate how the scanning of the hall elements is simplified.

According to the invention, a joystick of the type described in the introduction is characterised in that the hall effect switches are connected to a microprocessor adapted to periodically detect whether the individual hall effect switch short-circuits. The associated electronic circuits may thereby control an almost arbitrarily large number of positions where the joystick may engage indentations without the circuits for that reason being rendered correspondingly complicated.

According to the invention, the distance between the magnetizing means and the hall effect switch which is desired to be activated may be about 1 mm.

Furthermore, according to the invention, nine hall effect switches may be provided on the subjacent plate. It is thereby possible to control up to nine functions.

According to the invention, the detection of the position of the joystick takes place by a supply voltage being supplied to each of the hall effect switches one at a time from the microprocessor through some of the pins.

The invention is explained in greater details below with reference to the drawings in which

Figure 1 shows a contactless joystick according to the invention,

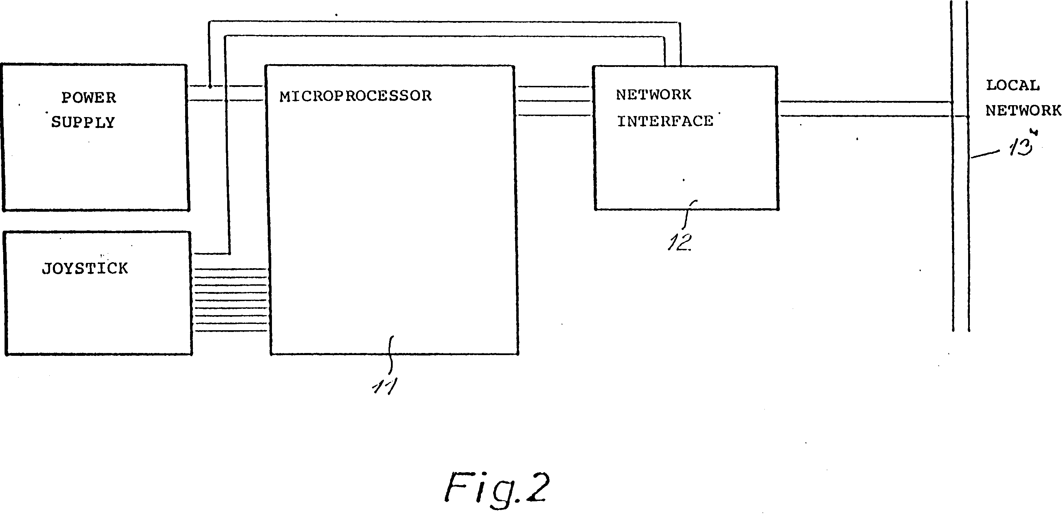

Figure 2 is a block diagram of the associated electronic circuits for the detection of the position of the joystick,

Figure 3 is a detailed diagram of the circuit of the joystick,

Figure 4 is a detailed diagram of the circuit for the detection of the position of the joystick,

Figure 5 shows the joystick on a large scale,

Figure 6 shows the hall effect switches in the joystick,

Figure 7 shows a plate shaped body, the indentations of which the lower portion of the joystick may engage in predetermined positions,

Figure 8 is a plan view of the plate-shaped body, and

Figure 9 shows the plate shaped body shown in Figure 7 seen from below.

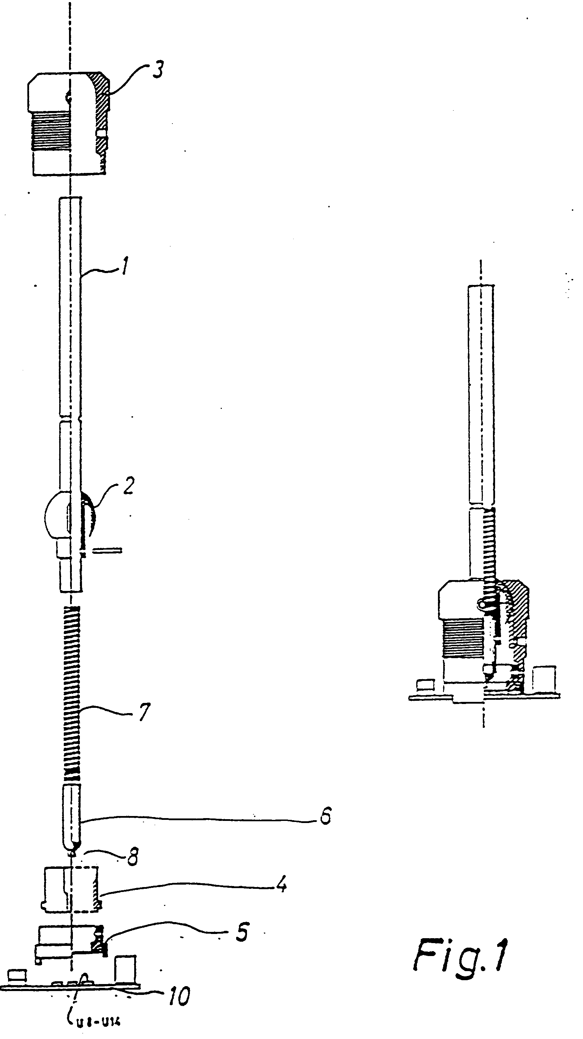

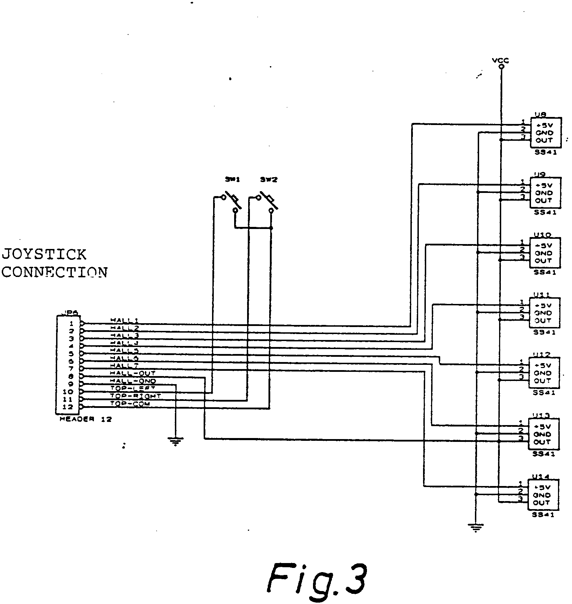

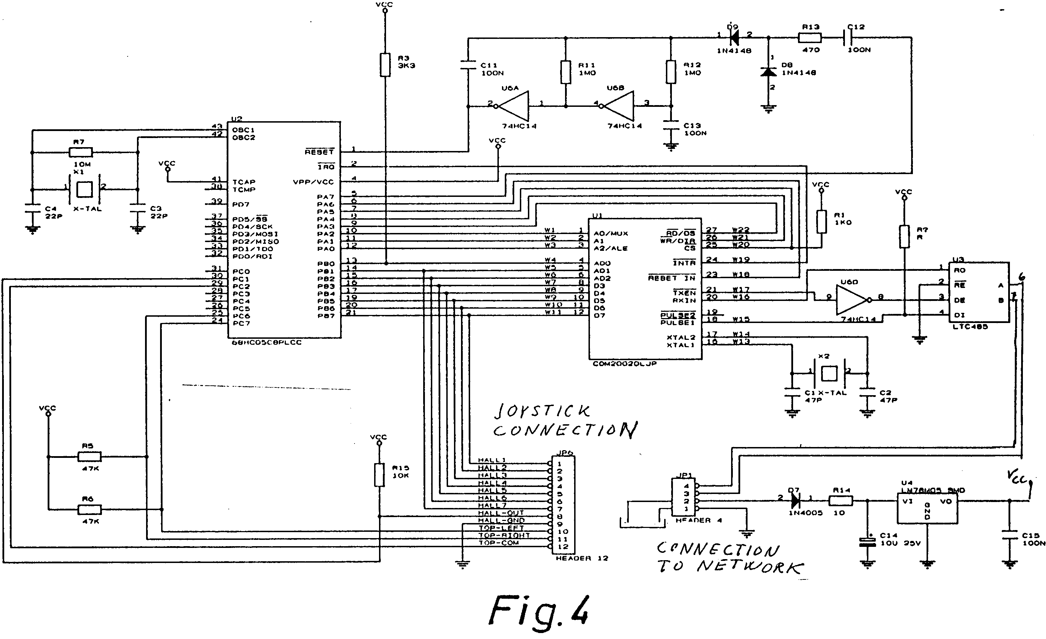

The joystick shown in Figure 1 comprises a swingable stick 1 in the form of a carrying pipe for a handle. A ball 2 is situated on the stick 1, said ball being suspended in a ball-and-socket joint. The ball-and-socket joint comprises a housing 3 which has been lowered over the ball 2, a backstop 4 being provided from the other side, said backstop engaging the housing 3 by means of projecting pins, and a lower portion which is fastened to the housing 3 by means of a split pin. The lower portion of the stick 1 is provided with a displacable portion 6, which has been biased in a downwards direction by means of a spring 7 fastened to the displacable portion 6. The displacable portion 6 serves to determine the position of the stick 1. A strong magnet 8, for instance in the form of a cobalt magnet, is provided at the end of the displacable portion 6. A number of hall effect switches, for instance 7 hall effect switches, are placed under the magnet 8. When the magnet 8 is placed opposite one of the hall effect switches, the distance to the hall effect switch is about 1 mm. The hall effect switches are mounted on a circuit board 10 situated at the bottom of the housing 3. The circuit board 10 is provided with two outlets. One outlet is for connection to two contacts SW1, SW2 in the handle of the stick 1, while the other outlet is for connection to the hall effect switches U8-U14. The associated electronic circuits - see Figure 4 - for detection of the position of the stick 1 comprises a microprocessor 11 (68HCO5C8), a network interface 12 (COM 20020) and a local area network of two wires. The necessary voltage supply is also provided. The position of the stick is detected by means of the seven hall effect switches U8-U14 seen to the right in Figure 3, the magnet 8 at the bottom of the displacable portion 6 being detectable by means of said hall effect switches U8-U14. There is room for up to nine different positions of the stick 1. A scanning is now carried out to determine if one of the hall effect switches U8-U14 short-circuits, the output of the hall effect switch in question short-circuiting to the frame, thereby indicating the position of the stick 1. The signal is carried to a multioutlet JP6. The scanning of the positon of the stick 1 takes place by the hall effect switches U8-U14 being activated one by one in that the supply voltage is supplied to each of the hall effect switches U8-U14 from the microprocessor 11 via the pins PB1-PB7. The activation is controlled by a program in the microprocessor 11. Each of the hall effect switches U8-U14 is activated for a short moment, for instance 1 msec. From pin PB 1 a signal is supplied to the hall effect switch No. 7 which is thereby activated. If there is a magnet opposite hall effect switch No. 7, the hall effect switch will short-circuit to the frame or ground; otherwise it will be drawn to $V_{cc}$, that is +5 V. If it is drawn to the frame, it is known that the stick 1 is opposite this hall effect switch, and via the multioutlet JP6 a signal appears on the line WALL-OUT. The signal on WALL-OUT is transmitted to a pin PC1 of the microprocessor 11 which checks if the signal is high or low. It is low if the hall effect switch short-circuits to the frame and it is high if the hall effect switch is not activated. Information is thereby provided on the position of the stick 1. Furthermore, information is provided on whether the switch should be turned on or off, as signals from some switches SW1 and SW2 in the handle of the stick are supplied to the microprocessor 11 and causes the function in question to be either switched on or off. Further, at flag is set if the switch is to be turned on. The microprocessor 11 communicates some hundred times a second with a local network 13 via an interface 12 COM 20020 and transmits messages via the network 13. This takes place through the pins PB0-PB7 and PA0-PA7 of the microprocessor. The signals from the pins PB0-PB7 are transmitted to the interface 12 which contains a protocol. A signal is then transmitted from the interface 12 at the terminals PULSE1 and TXEN. TXEN indicates whether the interface 12 sends or receives. The weak logical signals from the interface 12 are transformed by an output stage LTC 485 into stronger signals which are in opposite phase (to avoid noise). LTC 485 has the terminals RO (receive out) corresponding to received signal out, that is to the interface 12, RE (receive enable) which is activated by being connected to the frame, DE (data enable) which is data out to the local network 13 and DI (data input). Further there is an output A and an inverted output B. The signal from the output A is transmitted to an outlet JP1 connectable to the two conductors in the local network 13. The plus and minus terminals of the voltage supply are situated in the same outlet, said voltage supply supplying the voltage $V_{cc}$ through a voltage stabilisator U4. The pins A0, A1, and A2 in the interface 12 selects eight internal registers containing different information. Data is supplied by the pins AD0-D7. Data may be transferred both in and out and the pins PB0-PB7 of the microprocessor 11 may function both as inlets and as outlets. It is now assumed that a transfer of information from the microprocessor 11 to the interface 12 is desired. The pins PB0-PB7 of the microprocessor 11 are then set to be outlets and the interface 12 is then set to receive what is sent from said pins. Subsequently, the data are set up which the interface 12 COM 20020 is to receive and by means of A0-A2 the register is selected in which the received data are to be stored. Pin WR is then drawn or connected to the frame and input is carried out into the interface COM 20020. If data is to be received therefrom, the gate PB is set to receive. The address is at A0-A2 and the information to be received from the interface 12 is selected through A0-A2. The pin RD (pin 27) is then drawn or connected to the frame and it is then possible to read data, for instance containing information on the position of a boom. The microprocessor 11 starts its program when reset is connected to the frame. However, firstly the pins are set up which are necessary for the functioning of the remaining portion of the system while an internal watch is simultaneously scanned. The micro processsor is in a zero position. IRQ is connected to the pin INTR which is drawn or connected to the frame, when it has the information to be transferred. It thereby switches off the microprocessor instantaneously, irrespective of its activity, except if its activities have been interrupted. Otherwise, it stops the activities of the microprocessor and it then takes over the performance of the program concerning the communication in such a manner that data is removed from the interface COM 20020 as quickly as possible to be treated. This has nothing to do with RESET. The RESET circuit comprises a condensator C13. The signal on the condensator C13 is inverted twice, that is it is the same signal which is supplied from pin 20 of a Schmitt-trigger 74 HC14. 74 HC14 is connected to the condensator C13. The Schmitt-trigger causes the output to be low until the voltage on C13 has risen to e.g. 3 V. When it rises above 3 V the output goes high and remains high until the voltage of C13 has fallen to below e.g. 2 V corresponding to a hysteresis in 74 HC 14. When starting up the microprocessor 11, it alternately connects or draws pin 5 (PA7) to the frame and to plus whereby a charge is pumped via IRQ through a condensator C12, a resistor R13 and two diodes D8 and D9 and into a condensator C11. Thereby pin 3 on 74 HC14 remains high. If the microprocessor suddenly stops, is will cease pumping charge. The circuit thereby becomes unstable whereby it constantly changes between high and low on the output, corresponding to it transmitting reset pulses to the microprocessor 11 until said microprocessor has been started in a normal way again. This is called a watchdog (safety circuit).

The joystick is now assumed to be set in a definite position to control a predetermined function. The microprocessor 11 then scans the position of the joystick and whether the function in question is to be switched on or off. The microprocessor 11 subsequently stores the signals internally and transmits the signals as a number of words to the local network 13, which words contain information. The protocol in the interface 12 provides the transmitted words with a predetermined meaning (via pin 3 and pin 4 on JP1).

The bit flow supplied to the local network 13 is received by a corresponding circuit of e.g. a boom function, which in its turn gives a corresponding signal on a pin. A further microprocessor may optionally be adapted, said microprocessor supplying a signal corresponding to the signal on the pin for activation of e.g. a valve. However, the latter takes place a different place. The principle is that all information is transformed into signals transmittable by means of two conductors, irrespective of the amount of information, the information being in a bit flow but being registable by the receiver in order for the receiver to ascertain if the information is for it or for one of the other receivers.

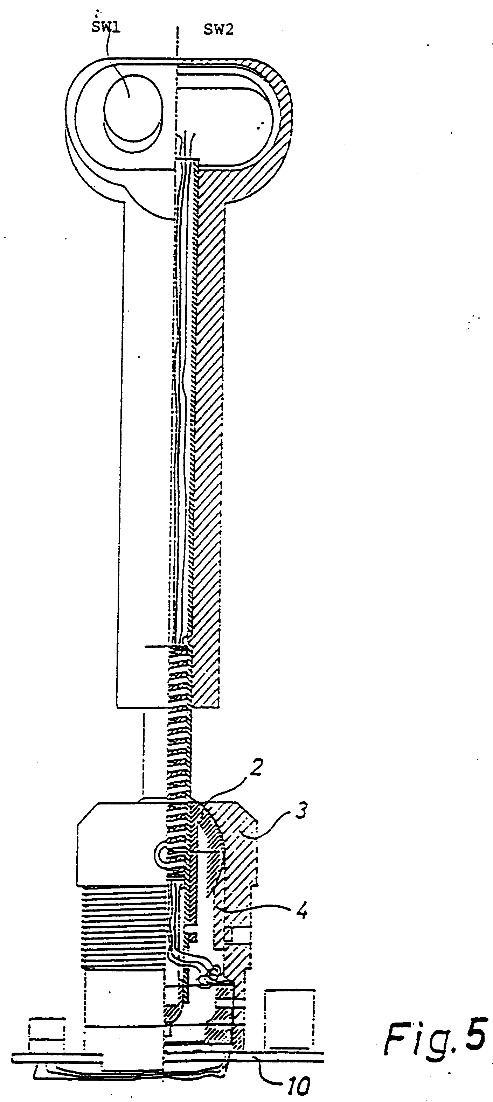

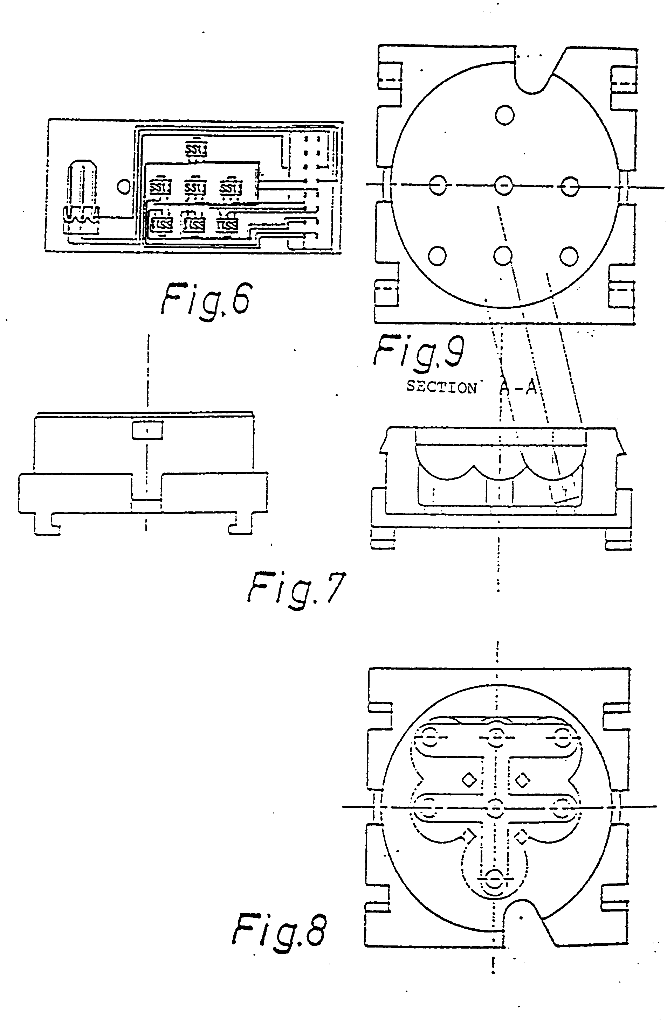

Figure 5 shows the joystick in its entirety. The contacts SW1 and SW2 are seen at the top. Wires are carried from the contacts to outlet 1 of the printed circuit board 10 shown in Figure 6, onto which the seven hall effect switches have also been mounted. Figures 7, 8 and 9 show a substantially plate-shaped body into which the lower portion of the spring biased portion may engage the indentations. The lower portion of the biased portion is rounded corresponding to the indentations of the substantially plate-shaped body. Figure 8 is a plan view of the plate-shaped body. It is seen that the outer projecting portion of the biased portion of the stick 1 where the magnet 8 is placed may be moved in a double F-shaped groove with indentations. Each of the holes shown in Figure 9 is opposite a hall effect switch.

In an alternative embodiment the field generating means are radiation emitting means while the transducers are radiation sensitive means. The radiation used may for instance be light, in which case the radiation emitting means is a light diode, while the radiation sensitive means are light sensitive semiconducting devices.

In a further alternative embodiment the radiation is ultrasound, both the transmitter and the receiver being an ultrasound transducer.

Finally, the radiation may be radioactive radiation, in which case a radioactive source is provided at the end of the biased portion of the stick 1, while the transducers are elements sensitive to radioactive radiation.

In an alternative embodiment a coding element has been provided in the printed circuit board in each of the positions which the swingable stick may engage. By means of the signals reflected from the point of the swingable stick (the displacable portion 6) the encoder element is able to ascertain whether the swingable stick is in a certain position or not. By means of reflexions from the point of the joystick it is thus possible to determine if this is present or not and this is done by means of a encoder element containing both a transmitter and a receiver. The encoder element may for instance work by means of ultrasound, thermal energy, radiowaves from the UHF range and upwards, radioactive radiation or light, the whole spectre. Alternatively, the encoder element may be influenced by a field distortion or a capacity change and thereby provide information on whether the swingable stick is in a certain position or not.

The joystick may for instance be used to control the following functions:

1. Unfolding of the individual boom sections
2. Raising and lowering of the boom
3. Boom slanting control
4. Foam amount regulation

The joystick controls the above functions via a local network. All data are transmitted via a screened cable with only one inner conductor. Interface of the type RS232C may be used for instance in connection with hydraulic valves, pressure gauges etc.

## Claims

1. Contactless joystick comprising a stick (1) swingable about a ball-and-socket joint (2), said stick comprising an upper portion and a lower portion (6) displacable relative to the upper portion, an elastic spring connected to the upper portion and the lower portion and biasing the lower portion (6), field generating means, such as magnetizing means mounted at the end of the lower portion (6) and a number of transducers, such as hall effect switches (U8-U14) mounted on a subjacent plate (10), where the lower biased portion (6) of the stick (1) is adapted to engage indentations in positions corresponding to the positions of the transducers, characterised in that the hall effect switches (U8-U14) are connected to a micro processor (11) adapted to periodically scan whether one of the hall effect switches short-circuits.

2. A joystick as claimed in claim 1, characterised by the distance between the magnetizing means (8) and the hall effect switch to be activated being about 1 mm.

3. A joystick as claimed in claim 1 or 2, characterised in that the nine hall effect switches (U8-U14) have been arranged on the subjacent plate (10).

4. A joystick as claimed in claim 1, characterised in that the upper part of the stick (1) has a locking groove (9) for the spring (7).

5. A joystick as claimed in the claims 1-4, characterised in that the scanning of the position of the joystick takes place by the supply voltage being supplied to each of the hall effect switches (U8-U14) one at a time from the micro processor (11) through some pins (PB1-PB7).

6. A joystick as claimed in claim 5, characterised in that the activation of the individual hall effect switch (U8-U14) lasts for 1 msec.

7. A joystick as claimed in claim 1, characterised in that the field generating means are radiation emitting means, while the transducers are radiation sensitive means.

*Fig.1*

Fig.2

POWER SUPPLY

JOYSTICK

MICROPROCESSOR

NETWORK INTERFACE

LOCAL NETWORK

13

12

11

8

EP 0 501 906 A1

*Fig.3*

Fig.4

Fig.5

Fig.6

Fig.7

Fig.9

SECTION A-A

Fig.8

**European Patent Office**

**EUROPEAN SEARCH REPORT**

Application Number

EP 92 61 0012

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| A | US-A-4 489 303 (THOMAS B. MARTIN) 18 December 1984<br>* abstract *<br>* column 3, line 33 - line 39 * | 1 | G06K11/18<br>G06K11/20 |
| A | IBM TECHNICAL DISCLOSURE BULLETIN.<br>vol. 23, no. 8, January 1981, NEW YORK US<br>pages 3831 - 3834;<br>J.E.FOX: 'Scanned Capacitive Joy Stick Cursor Control'<br>* page 3833, paragraph 3 * | 1 | |
| | | | **TECHNICAL FIELDS SEARCHED (Int. Cl.5 )**<br><br>G06K<br>G06F |

The present search report has been drawn up for all claims

| Place of search | Date of completion of the search | Examiner |
|---|---|---|
| THE HAGUE | 26 MAY 1992 | CIARELLI N. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.................................................................................

& : member of the same patent family, corresponding document

EPO FORM 1503 03.82 (P0401)